# EUROPEAN PATENT APPLICATION

(11) **EP 4 779 730 A1**
(43) Date of publication of application: **22.07.2026**
(21) Application number: 25221659.3
(22) Date of filing: 09.12.2025
(51) Int. Cl.: H01M 8/04537, H01M 8/04664, H01M 8/04858, H01M 8/249

(54) **VOLTAGE DETECTION SYSTEM**

(30) Priority: 20.01.2025 JP 2025007306
(71) Applicant: Toyota Jidosha Kabushiki Kaisha, Toyota-shi, Aichi-ken 471-8571 (JP)
(72) Inventor: NAKAGAWA, Noritoshi, Toyota-shi, 471-8571 (JP)
(74) Representative: TBK

(57) **Abstract**

A voltage detection system includes: cell voltage monitors; and electronic elements each having a resistive component with a respective different resistance value. Each of the cell voltage monitors includes: a memory storing inspection information that represents predetermined association between a physical quantity correlated to a resistance value and each of the inspection logics; an acquirer that acquires the physical quantity of the electronic element connected to the cell voltage monitor itself; and a detector that detects the voltage from a corresponding cell of the cells under a selected one of the inspection logics. The detector selects the inspection logic to be used using the acquired physical quantity and the inspection information.

## Description

### BACKGROUND

### FIELD

The present disclosure relates to a voltage detection system.

### RELATED ART

There is a conventional device that detects voltages from stacked cells of a fuel cell using a plurality of cell voltage detection devices (Japanese Patent Application Publication No. 2017-173071, for example).

In some cases, all the cell voltage detection devices are required to adopt cell voltage detection methods differing from each other. Patent Literature 1 does not give consideration to a method of adopting detection methods differing from each other between the plurality of cell voltage detection devices.

### SUMMARY

The present disclosure is feasible in the following aspects.
(1) According to an aspect of the present disclosure, a voltage detection system is provided. The voltage detection system is used for a fuel cell stack including a plurality of cells stacked on each other and divided into a plurality of groups. The voltage detection system comprises: a plurality of cell voltage monitors configured to detect a voltage from one cell or two or more cells of the plurality of cells as a unit; and a plurality of electronic elements each having a resistive component with a respective different resistance value. Each of the plurality of electronic elements is connected to a corresponding cell voltage monitor of the plurality of cell voltage monitors. Each of the plurality of cell voltage monitors is associated with a respective one of the plurality of groups. Each of the plurality of cell voltage monitors includes: a memory storing inspection information that represents predetermined association between a physical quantity correlated to the resistance value and a corresponding inspection logic of inspection logics used for detecting the voltage; an acquirer configured to acquire the physical quantity of the electronic element of the plurality of electronic elements connected to the cell voltage monitor itself; and a detector configured to detect the voltage from a corresponding cell of the plurality of cells under a selected inspection logic of the plurality of inspection logics. The detector selects the inspection logic to be used from the plurality of inspection logics using the acquired physical quantity and the inspection information. According to this aspect, it is possible for the plurality of cell voltage monitors to adopt the inspection logics differing from each other.
(2) In the voltage detection system according to the above aspect, the memory may store identifier information representing predetermined association between the physical quantity and a communication identifier, and each of the cell voltage monitors may include a decider configured to determine the communication identifier using the acquired physical quantity and the identifier information. According to this aspect, each of the plurality of cell voltage monitors is capable of determining the communication identifier differing from that for another cell voltage monitor by acquiring the physical quantity correlated to the resistance value of the electronic element connected to the cell voltage monitor itself.
(3) In the voltage detection system according to the above aspect, each of the plurality of inspection logics may stipulate the unit used for detection of the voltage in response to the position of each of the plurality of cells in a stacking direction. According to this aspect, it is possible to stipulate the unit used for detection of the voltage in response to the position of the cell in the stacking direction.
(4) In the voltage detection system according to the above aspect, the plurality of cells may include a highest-order cell, a lowest-order cell, and middle cells between the highest-order cell and the lowest-order cell, the plurality of groups may include a first group to which the highest-order cell belongs and a second group to which the lowest-order cell belongs, the plurality of inspection logics may include a first inspection logic corresponding to the first group and a second inspection logic corresponding to the second group, the first inspection logic may stipulate that the voltage be detected from one cell as the unit for the highest-order cell and stipulate that the voltage be detected from two or more cells as the unit for the middle cells, and the second inspection logic may stipulate that the voltage be detected from one cell as the unit for the lowest-order cell and stipulate that the voltage be detected from two or more cells as the unit for the middle cells. According to this aspect, regarding the highest-order cell and the lowest-order cell where generated water is likely to retain, it is possible to detect a voltage with high accuracy from the cell. Regarding the middle cells where a level of detection accuracy is not required to be as high as that required for the highest-order cell and the lowest-order cell, a voltage is detected from two or more cells as a unit to achieve reduction in processing load required for voltage detection or communication of voltage data.
(5) In the voltage detection system according to the above aspect, each of the plurality of cell voltage monitors may include a connector to which a wiring is connected, and each of the plurality of electronic elements may be connected to the connector via the wiring. According to this aspect, it is possible to use circuit boards common to the plurality of cell voltage monitors. In this way, reduction in manufacturing cost is achieved.

The present disclosure may be realized in various types of aspects. For example, in addition to the fuel cell system, the present disclosure may be realized in aspects including a method of controlling the fuel cell system, a computer program for causing a computer to implement such a control method, and a non-transitory and tangible recording medium in which the computer program is recorded readably.

### BRIEF DESCRIPTION OF THE DRAWINGS

Fig. 1 is a view showing a schematic configuration of a fuel cell system to be mounted on a vehicle;
Fig. 2 is a block diagram showing an electrical configuration of a cell voltage monitor; and
Fig. 3 is a flowchart showing a processing procedure of detecting a cell voltage.

### DETAILED DESCRIPTION

### A. Embodiment

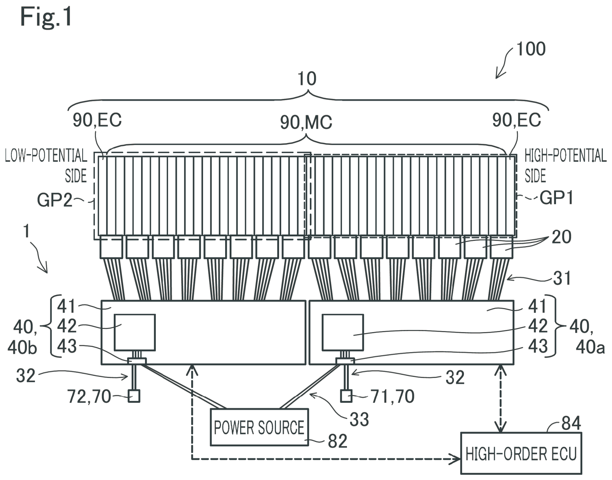

Fig. 1 is a view showing a schematic configuration of a fuel cell system 100 to be mounted on a vehicle. The fuel cell system 100 includes a fuel cell stack 10 and a voltage detection system 1. The voltage detection system 1 includes a plurality of cell voltage monitors 40, a plurality of resistors 70 as a plurality of electronic elements, a power source 82, and a high-order ECU 84.

The fuel cell stack 10 generates power by causing power generation reaction using a fuel gas and an oxidizing gas. The fuel cell stack 10 is a polymer electrolyte fuel cell and has a stack structure with a plurality of stacked cells 90. The cell 90 has a configuration where a membrane electrode and gas diffusion layer assembly (MEGA) not shown in the drawings is interposed by separators not shown in the drawings. The MEGA includes a membrane electrode assembly (MEA), and gas diffusion layers arranged on both surfaces of the MEA. The MEA includes an electrolyte membrane, an electrode catalyst layer functioning as an anode formed on one of surfaces of the electrolyte membrane, and an electrode catalyst layer functioning as a cathode formed on the other surface of the electrolyte membrane. In the present embodiment, hydrogen is used as the fuel gas and oxygen in air is used as the oxidizing gas.

The fuel cell stack 10 of the present embodiment is mounted on a commercial vehicle such as a truck or a bus, for example. Requested power required for the fuel cell stack 10 to be mounted on a commercial vehicle is larger than requested power required for the fuel cell stack 10 to be mounted on a passenger vehicle. For this reason, the number of the stacked cells 90 in the present embodiment is larger than the number of the stacked cells 90 in the fuel cell stack 10 to be mounted on a passenger vehicle. In the present embodiment, the number of the stacked cells 90 is about several hundreds, for example.

The cell 90 is provided with a voltage detection terminal not shown in the drawings for detecting a cell voltage corresponding to an anode-to-cathode voltage. A cell connector 20 is electrically connected to the voltage detection terminal of the cell 90.

The plurality of cell voltage monitors 40 includes a first cell voltage monitor 40a and a second cell voltage monitor 40b. If the first cell voltage monitor 40a and the second cell voltage monitor 40b are not distinguished from each other, they will be called a cell voltage monitor 40 simply. The cell voltage monitor 40 detects a voltage from one or two or more cells 90 as a unit. In the present embodiment, the cell voltage monitor 40 detects a voltage from one cell 90 as a unit regarding cells 90 at both ends in a stacking direction in the fuel cell stack 10. The cell voltage monitor 40 detects a voltage from two cells 90 as a unit regarding cells 90 in a middle between the cells 90 at the both ends in the fuel cell stack 10. This makes it possible to acquire a voltage with high accuracy from an end cell EC where generated water is likely to retain. In the fuel cell stack 10, the cell 90 at the end is also called the end cell EC, and the cell 90 in the middle is also called a middle cell MC.

The plurality of cells 90 is divided into a plurality of groups. In the present embodiment, the plurality of cells 90 is divided into a first group GP1 and a second group GP2. The first group GP1 and the second group GP2 are arranged side by side in the stacking direction of the cells 90. The first cell voltage monitor 40a corresponds to the first group GP1. The second cell voltage monitor 40b corresponds to the second group GP2. The cells 90 belonging to the first group GP1 are high-potential side cells 90 in the fuel cell stack 10. The cells 90 belonging to the second group GP2 are low-potential side cells 90 in the fuel cell stack 10. Regarding the plurality of cells 90, the high-potential side cells 90 are also called high-order cells 90, and the low-potential side cells 90 are also called low-order cells 90. In the fuel cell stack 10, the high-potential side cell 90 of the two end cells EC is also called a highest-order cell 90. In the fuel cell stack 10, the low-potential side cell 90 of the two end cells EC is also a lowest-order cell 90. Specifically, the first group GP1 includes the highest-order cell 90 in the fuel cell stack 10, and the second group GP2 includes the lowest-order cell 90 in the fuel cell stack 10. In the present disclosure, "being divided" means that two or more cells 90 connected to the same cell voltage monitor 40 are categorized as one group.

The cell voltage monitor 40 includes a substrate 41, a microcomputer 42, and a connector 43. The microcomputer 42 and the connector 43 are mounted on the substrate 41. The cell connector 20 and the microcomputer 42 are electrically connected to each other via a first wire harness 31, a connector not shown in the drawings mounted on the cell voltage monitor 40, and a wiring not shown in the drawings formed on the substrate 41.

The microcomputer 42 and the connector 43 are electrically connected to each other via a wiring formed on the substrate 41. The connector 43 and the resistor 70 are electrically connected to each other via a second wire harness 32 as a wiring. The connector 43 and the power source 82 are electrically connected to each other via a third wire harness 33. The power source 82 supplies driving power to the microcomputer 42. In the present embodiment, the cell voltage monitor 40 and the resistor 70 are connected to each other using an empty terminal of the connector 43 used for forming connection between the power source 82 and the cell voltage monitor 40. This achieves connection of the resistor 70 without adding a connector for connection of the resistor 70, making it possible to reduce manufacturing cost and suppress increase in physical size of the cell voltage monitor 40.

The high-order ECU 84 controls the fuel cell system 100 in a centralized manner. The high-order ECU 84 and the cell voltage monitor 40 communicate with each other according to a controller area network (CAN) and using a signal line not shown in the drawings. The cell voltage monitor 40 transmits a cell voltage that is a voltage detected from the cell 90 to the high-order ECU 84. The high-order ECU 84 controls the amount of supply of the fuel gas or the amount of supply of air to be supplied to the fuel cell stack 10 using the cell voltage, for example. Generated water is likely to retain in the end cell EC as described above. The retention of the generated water in the fuel cell stack 10 causes insufficient supply of air, so that the cell voltage becomes a negative voltage to cause deterioration of the cell 90. In response to this, on the occurrence of reduction in the cell voltage, the high-order ECU 84 exerts control of supplying air abundantly, for example. By doing so, the deterioration of the cell 90 is suppressed.

The resistor 70 is an electronic element having a resistive component to DC power. The resistor 70 connected to the first cell voltage monitor 40a and the resistor 70 connected to the second cell voltage monitor 40b have resistance values differing from each other. The resistor 70 connected to the first cell voltage monitor 40a is also called a first resistor 71. The resistor 70 connected to the second cell voltage monitor 40b is also called a second resistor 72. In the present embodiment, the first resistor 71 has a resistance value smaller than the resistance value of the second resistor 72.

In the present embodiment, the resistor 70 is connected via the second wire harness 32 instead of being mounted on the substrate 41. Thus, it is possible to use circuit boards common to the first cell voltage monitor 40a and the second cell voltage monitor 40b. It is further possible to connect the high-potential resistor 70 to the high-potential side cell voltage monitor 40 and connect the low-potential resistor 70 to the low-potential side cell voltage monitor 40 after the cell voltage monitors 40 are connected to the fuel cell stack 10. Specifically, in a step of connecting the cell voltage monitors 40 to the fuel cell stack 10 during a manufacturing process, it is not required to make distinction between the high-potential cell voltage monitor 40 and the low-potential cell voltage monitor 40.

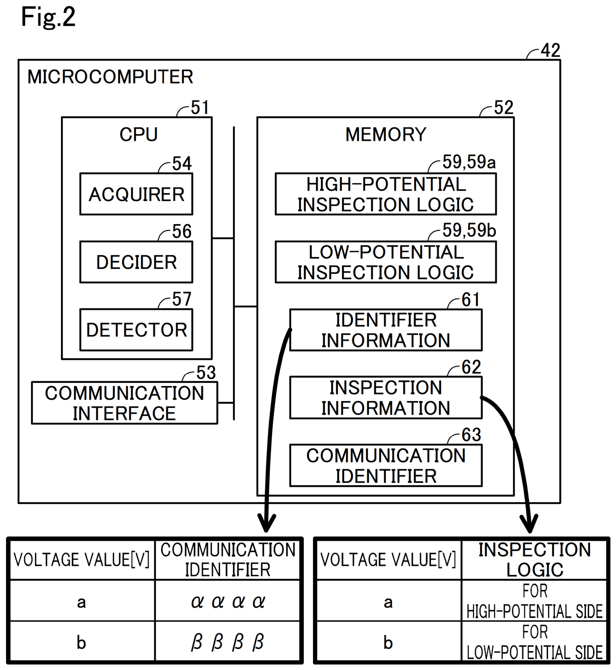

Fig. 2 is a block diagram showing an electrical configuration of the cell voltage monitor 40. The cell voltage monitor 40 includes a CPU 51, a memory 52, and a communication interface 53. The memory 52 is realized using a RAM or a ROM, for example. The communication interface 53 performs data conversion according to standards for the CAN, and makes CAN communication with the high-order ECU 84. The CPU 51, the memory 52, and the communication interface 53 are communicably connected to each other via a bus. The memory 52 contains a plurality of inspection logics 59, identifier information 61, and inspection information 62 that are stored in advance. In the present embodiment, the plurality of inspection logics 59 includes a high-potential inspection logic 59a as a first inspection logic, and a low-potential inspection logic 59b as a second inspection logic.

The memory 52 stores a communication identifier 63 determined by a decider 56 described later. The communication identifier 63 is a so-called CAN-ID that is an identifier for CAN communication to be assigned uniquely to a device to make CAN communication. The CPU 51 includes an acquirer 54, the decider 56, and a detector 57. The acquirer 54, the decider 56, and the detector 57 are functional units realized by execution of a program not shown in the drawings stored in the memory 52.

The identifier information 61 is information representing predetermined association between a voltage value of the resistor 70 acquired by the acquirer 54 and the communication identifier 63. The inspection information 62 is information representing association between a voltage value of the resistor 70 acquired by the acquirer 54 and either one of the high-potential inspection logic 59a and the low-potential inspection logic 59b.

As described above, the number of the stacked cells 90 in the fuel cell stack 10 of the present embodiment is larger than the number of the stacked cells 90 in the fuel cell stack 10 to be mounted on a passenger vehicle. Furthermore, the cell voltage monitor 40 for passenger vehicle is already in production. The fuel cell system 100 of the present embodiment uses two cell voltage monitors 40 for passenger vehicle already in production. This achieves reduction in manufacturing cost, compared to a case where efforts are made nearly such as making design of the substrate 41 of the cell voltage monitor 40 for commercial vehicles, etc.

As described above, in the present embodiment, the cell voltage monitor 40 detects a voltage from one cell 90 as a unit regarding the end cell EC, and detects a voltage from two cells 90 as a unit regarding the middle cells MC. As shown in Fig. 1, the highest-order cell 90 of the plurality of cells 90 connected to the first cell voltage monitor 40a is the end cell EC. By contrast, the lowest-order cell 90 of the plurality of cells 90 connected to the second cell voltage monitor 40b is the end cell EC. Thus, the first cell voltage monitor 40a and the second cell voltage monitor 40b are required to use the inspection logics 59 differing from each other. In response to this, efforts are made on the plurality of cell voltage monitors 40 of the present application for using the inspection logics 59 differing from each other. These efforts are new efforts not to be made on the cell voltage monitor 40 for passenger vehicle based on the assumption of use of one cell voltage monitor 40.

The inspection logic 59 is a program used for detecting a voltage. In the present embodiment, the inspection logic 59 includes the high-potential inspection logic 59a and the low-potential inspection logic 59b. If the high-potential inspection logic 59a and the low-potential inspection logic 59b are not distinguished from each other, they will also be called the inspection logic 59 simply. The inspection logic 59 stipulates a unit of the cell 90 used for voltage detection, a procedure of detecting voltages sequentially, and if voltages are detected from two or more cells 90 as a unit, a procedure of calculating an average of the detected voltages. The inspection logic 59 stipulates a unit used for voltage detection in response to the position of the cell 90 in the stacking direction.

As described above, in the present embodiment, the voltage detection terminal not shown in the drawings is provided to each of the anode and the cathode of the cell 90 among all the cells 90. All the voltage detection terminals and the microcomputer 42 are electrically connected to each other via the first wire harness 31, etc. The inspection logic 59 stipulates that a voltage be detected from one cell 90 as a unit regarding the end cell EC, and stipulates that voltages be detected from two cells 90 and an average of the detected voltages be calculated by dividing the detected voltages by 2 regarding the middle cells MC.

More specifically, in the present embodiment, the high-potential inspection logic 59a stipulates that a voltage be detected from one cell 90 as a unit regarding the highest-order cell 90, and stipulates that a voltage be detected from two cells 90 as a unit regarding the cells 90 other than the highest-order cell 90. By contrast, the low-potential inspection logic 59b stipulates that a voltage be detected from one cell 90 as a unit regarding the lowest-order cell 90, and stipulates that a voltage be detected from two cells 90 as a unit regarding the cells 90 other than the lowest-order cell 90.

The cell voltage monitor 40 makes CAN communication with the high-order ECU 84. The communication identifier 63 is used in the CAN communication. In order to avoid a collision between communications, the first cell voltage monitor 40a and the second cell voltage monitor 40b are required to be assigned with the communication identifiers 63 differing from each other. In response to this, efforts are made on the plurality of cell voltage monitors 40 for determining the respective communication identifiers 63 differing from each other.

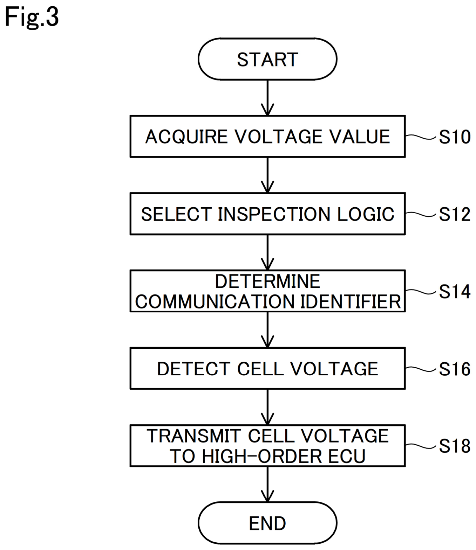

Fig. 3 is a flowchart showing a processing procedure of detecting a cell voltage performed by the microcomputer 42. After the microcomputer 42 is started, in step S10 in Fig. 3, the acquirer 54 acquires a voltage value of the resistor 70 connected to the cell voltage monitor 40 on which the acquirer 54 itself is mounted. Specifically, the acquirer 54 of the first cell voltage monitor 40a acquires a voltage from the first resistor 71. The acquirer 54 of the second cell voltage monitor 40b acquires a voltage in the second resistor 72. In the present embodiment, the cell voltage monitor 40 includes a series resistance not shown in the drawings connected in series with the resistor 70 and having a known resistance value, and a power source connected in series with a connected body including the series resistance and the resistor 70. Then, the acquirer 54 acquires a partial voltage in the resistor 70. A voltage in this power source and the resistance value of the series resistance are known values, so that the voltage in the resistor 70 is specifically a physical quantity correlated to a resistance value of the resistor 70.

The circuit configuration of a circuit including the resistor 70 is not limited to the above. As an example, the cell voltage monitor 40 may include a constant current source connected to the resistor 70, and the acquirer 54 may detect a voltage in the resistor 70 while a constant current flows therein.

In step S12, the detector 57 selects the inspection logic 59 to be used from the plurality of inspection logics 59. In the present embodiment, the first resistor 71 has a voltage value aV and the second resistor 72 has a voltage value bV. In the present embodiment, the inspection information 62 is set in the way shown in Fig. 2. Thus, if a voltage value is aV, the detector 57 selects the high-potential inspection logic 59a as the inspection logic 59 to be used. If a voltage value is bV, the detector 57 selects the low-potential inspection logic 59b as the inspection logic 59 to be used.

In step S14 in Fig. 3, the decider 56 determines the communication identifier 63 using the voltage value of the resistor 70 acquired by the acquirer 54 and the identifier information 61. In the present embodiment, the identifier information 61 is set in the way shown in Fig. 2. Thus, if the voltage value is aV, the decider 56 determines a communication identifier to be "αααα." If the voltage value is bV, the decider 56 determines a communication identifier to be "ββββ." The identifier information 61 is set in such a manner as to avoid an overlap between the two communication identifiers 63. Thus, the communication identifiers 63 differing from each other are determined for the first cell voltage monitor 40a and the second cell voltage monitor 40b. The decider 56 stores the determined communication identifier 63 into the memory 52. In making the CAN communication, the communication interface 53 uses the communication identifier 63 stored in the memory 52. By doing so, collision between communications is avoided during the CAN communication.

In step S16, the detector 57 detects a voltage from the cell 90 under the selected inspection logic 59. More specifically, in the present embodiment, the detector 57 detects voltages from the cells 90 in order in which the cells 90 are stacked. In step S18, the detector 57 transmits the detected voltages to the high-order ECU 84 via the communication interface 53, and then finishes this processing routine. The order of implementations of step S12, step S14, and step S16 is not limited to the above. For example, step S14 may be performed after implementations of step S12 and step S16. As another example, step S12 and step S14 may be performed concurrently.

According to the above-described embodiment, the fuel cell system 100 includes the fuel cell stack 10 with the plurality of stacked cells 90, the first cell voltage monitor 40a, the second cell voltage monitor 40b, and the two resistors 70 having resistance values differing from each other. The plurality of cells 90 is divided into the first group GP1 and the second group GP2. The first cell voltage monitor 40a corresponds to the first group GP1. The second cell voltage monitor 40B corresponds to the second group GP2. Each of the first cell voltage monitor 40a and the second cell voltage monitor 40b includes the acquirer 54 and the detector 57. The acquirer 54 acquires a voltage value of the connected resistor 70. The detector 57 selects which one of the high-potential inspection logic 59a and the low-potential inspection logic 59b is to be used using the voltage value acquired by the acquirer 54 and the inspection information 62. As a result, it is possible for the first cell voltage monitor 40a and the second cell voltage monitor 40b to adopt the inspection logics 59 differing from each other.

The identifier information 61 is stored in the memory 52. The cell voltage monitor 40 includes the decider 56. The decider 56 determines the communication identifier 63 using the voltage value acquired by the acquirer 54 and the identifier information 61. As a result, it is possible to determine the respective communication identifiers 63 for the first cell voltage monitor 40a and the second cell voltage monitor 40b in such a manner as to make a difference between these communication identifiers 63.

The inspection logic 59 stipulates a unit used for voltage detection in response to the position of the cell 90 in the stacking direction in the fuel cell stack 10. More specifically, the high-potential inspection logic 59a stipulates that a voltage be detected from one cell 90 as a unit regarding the highest-order cell 90 as the end cell EC, and stipulates that a voltage be detected from two cells 90 as a unit regarding the middle cells MC. The low-potential inspection logic 59b stipulates that a voltage be detected from one cell 90 as a unit regarding the lowest-order cell 90 as the end cell EC, and stipulates that a voltage be detected from two cells 90 as a unit regarding the middle cells MC. As a result, regarding the end cell EC where generated water is likely to retain, it is possible to detect a voltage with high accuracy from the cell 90. Regarding the middle cells MC where a level of detection accuracy is not required to be as high as that required for the end cell EC, a voltage is detected from two cells 90 as a unit to achieve reduction in processing load required for voltage detection or communication of voltage data.

The fuel cell system 100 includes the power source 82, the connector 43, and the second wire harness 32. The resistor 70 is connected to the cell voltage monitor 40 via the second wire harness 32. As a result, it is possible to use circuit boards common to the plurality of cell voltage monitors 40. In this way, reduction in manufacturing cost is achieved.

### B. Other Embodiments

(B1) In the above embodiment, a voltage value is used as a physical quantity correlated to a resistance value of the resistor 70. In another embodiment, the value of a current flowing in the resistor 70 may be used as a physical quantity correlated to a resistance value of the resistor 70. More specifically, the cell voltage monitor 40 may include a power source connected to the resistor 70, and the acquirer 54 may acquire the value of a current flowing in the resistor 70.

(B2) In the above embodiment, the resistor 70 is used as an electronic element having a resistive component. The electronic element having the resistive component is not limited to the resistor 70 but may be a different electronic element such as a diode, for example.

(B3) In the above embodiment, voltages are detected from two cells 90 regarding the middle cells MC. In another embodiment, voltages may be detected from three or more cells 90 regarding the middle cells MC. In the above embodiment, the fuel cell system 100 includes the two cell voltage monitors 40. In another embodiment, the fuel cell system 100 may include three or more cell voltage monitors 40.

(B4) In the above embodiment, the inspection logic 59 stipulates that a voltage be detected from one cell 90 as a unit regarding the end cell EC under the circumstances that generated water is likely to retain in the end cell EC. Depending on the configuration of the fuel cell stack 10, it may be requested to detect a voltage from one cell 90 as a unit regarding the cell 90 at the center of the fuel cell stack 10 in the stacking direction. In this case, the inspection logic 59 may stipulate that a voltage be detected from one cell 90 as a unit in response to a position in the stacking direction, namely, a voltage be detected from one cell 90 as a unit regarding the cell 90 at the center.

(B5) In the above embodiment, the cell voltage monitor 40 includes the microcomputer 42. The control circuit of the cell voltage monitor 40 is not limited to the microcomputer 42 but may be an application specific integrated circuit (ASIC), for example. In the above embodiment, the identifier information 61 and the inspection information 62 are each presented in the form of a table in Fig. 2. However, the data format is not limited to the table format. As an example, the cell voltage monitor 40 may be realized using an electronic circuit configured in such a manner as to change the communication identifier 63 and the inspection logic 59 to be adopted in response to a voltage value acquired by the acquirer 54.

(B6) In the above embodiment, the resistor 70 is connected to the cell voltage monitor 40 via the second wire harness 32. In another embodiment, the resistor 70 may be mounted on the substrate 41. In the above embodiment, the first group GP1 and the second group GP2 are arranged side by side in the stacking direction of the cells 90. In another embodiment, the plurality of cells 90 may be divided in such a manner that one of the cells 90 next to each other belongs to the first group GP1 and the other belongs to the second group GP2, for example.

The present disclosure is not limited to the embodiments described above and is able to be realized with various configurations without departing from the spirit thereof. For example, technical features in the embodiments corresponding to the technical features in the aspects described in the section of SUMMARY are able to be replaced with each other or combined together as necessary in order to solve part or the whole of the problems described previously or to achieve part or the whole of the effects described previously. When the technical features are not described as essential features in the present specification, they are able to be deleted as necessary.

## Claims

1. A voltage detection system (1) used for a fuel cell stack (10) including a plurality of cells (90) stacked on each other and divided into a plurality of groups (GP1, GP2), comprising:
a plurality of cell voltage monitors (40a, 40b) configured to detect a voltage from one cell or two or more cells of the plurality of cells (90) as a unit; and
a plurality of electronic elements (71, 72) each having a resistive component with a respective different resistance value, wherein
each of the plurality of electronic elements (71, 72) is connected to a corresponding cell voltage monitor of the plurality of cell voltage monitors (40a, 40b),
each of the plurality of cell voltage monitors (40a, 40b) is associated with a respective one of the plurality of groups (GP1, GP2),
each of the plurality of cell voltage monitors (40a, 40b) includes:
a memory (52) storing inspection information (62) that represents predetermined association between a physical quantity correlated to the resistance value and a corresponding inspection logic of a plurality of inspection logics (59a, 59b) used for detecting the voltage;
an acquirer (54) configured to acquire the physical quantity of the electronic element of the plurality of electronic elements (71, 72) connected to the cell voltage monitor itself; and
a detector (57) configured to detect the voltage from a corresponding cell of the plurality of cells (90) under a selected inspection logic of the plurality of inspection logics (59a, 59b), wherein the detector (57) selects the inspection logic to be used from the plurality of inspection logics (59a, 59b) using the acquired physical quantity and the inspection information (62).

2. The voltage detection system (1) according to claim 1, wherein
the memory (52) stores identifier information (61) representing predetermined association between the physical quantity and a communication identifier, and
each of the plurality of cell voltage monitors (40a, 40b) includes a decider (56) configured to determine the communication identifier using the acquired physical quantity and the identifier information (61).

3. The voltage detection system (1) according to claim 1 or 2, wherein
each of the plurality of inspection logics (59a, 59b) stipulates the unit used for detection of the voltage in response to the position of each of the plurality of cells (90) in a stacking direction.

4. The voltage detection system (1) according to claim 3, wherein
the plurality of cells (90) includes a highest-order cell, a lowest-order cell, and middle cells between the highest-order cell and the lowest-order cell,
the plurality of groups (GP1, GP2) includes a first group (GP1) to which the highest-order cell belongs and a second group (GP2) to which the lowest-order cell belongs,
the plurality of inspection logics (59a, 59b) includes a first inspection logic (59a) corresponding to the first group (GP1) and a second inspection logic (59b) corresponding to the second group (GP2),
the first inspection logic (59a) stipulates that the voltage be detected from one cell as the unit for the highest-order cell and stipulates that the voltage be detected from two or more cells as the unit for the middle cells, and
the second inspection logic (59b) stipulates that the voltage be detected from one cell as the unit for the lowest-order cell and stipulates that the voltage be detected from two or more cells as the unit for the middle cells.

5. The voltage detection system (1) according to claim 1, wherein
each of the plurality of cell voltage monitors (40a, 40b) includes a connector (43) to which a wiring (32) is connected, and
each of the plurality of electronic elements (71, 72) is connected to the connector (43) via the wiring (32).
